(19)

**Europäisches Patentamt**

**European Patent Office**

**Office européen des brevets**

(11) **EP 3 339 094 A1**

(12) **DEMANDE DE BREVET EUROPEEN**

(43) Date de publication:
**27.06.2018  Bulletin 2018/26**

(51) Int Cl.:
**B60Q 1/26** (2006.01)  **H05K 1/18** (2006.01)
**F21Y 115/10** (2016.01)

(21) Numéro de dépôt: **17190846.0**

(22) Date de dépôt: **13.09.2017**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**MA MD**

(30) Priorité: **28.09.2016  FR 1659231**

(71) Demandeur: **Valeo Vision**
**93012 Bobigny Cedex (FR)**

(72) Inventeurs:
 • **COLLOT, Patrice**
  **93012 BOBIGNY Cedex (FR)**
 • **GODBILLON, Vincent**
  **75011 PARIS (FR)**

 • **MILLON, Franck**
  **93012 BOBIGNY Cedex (FR)**
 • **KINFACK, Jean-Didier**
  **93012 BOBIGNY Cedex (FR)**
 • **SEIF, Lothar**
  **93012 BOBIGNY Cedex (FR)**
 • **AUDY, Natacha**
  **93012 BOBIGNY Cedex (FR)**
 • **ZHU, Lingxuan**
  **93012 BOBIGNY Cedex (FR)**
 • **ABALA, Arnaud**
  **93012 BOBIGNY Cedex (FR)**

(74) Mandataire: **Valeo Vision**
**IP Department**
**34, rue Saint André**
**93012 Bobigny (FR)**

(54) **MODULE D' ÉMISSION LUMINEUSE À COMMANDE AMÉLIORÉE NOTAMMENT POUR VÉHICULE AUTOMOBILE**

(57)     Un module d'émission lumineuse, notamment pour véhicule automobile.

Le module comprend :
- un substrat (14) comprenant une portion principale (20) courbe s'étendant selon une direction longitudinale (D),
- une pluralité d'éléments électroluminescents (16) agencés sur le substrat et configurés pour émettre des rayons lumineux lorsqu'alimentés en énergie électrique, les éléments électroluminescents étant distribués le long de ladite direction longitudinale, et
- un ensemble de commande (34) adapté pour réguler l'énergie électrique fournie aux éléments électroluminescents, l'ensemble de commande présentant un mode de fonctionnement dans lequel l'ensemble de commande est configuré pour la fourniture aux éléments électroluminescents (16) d'énergies et/ou puissances électriques respectives déterminées au moins en fonction de directions principales d'émission lumineuse (dp1, ..., dp6) respectives des éléments électroluminescents pour l'obtention d'au moins deux intensités lumineuses maximales émises par les éléments électroluminescentes selon la direction principale d'émission correspondante qui sont différentes le long de ladite direction longitudinale (D) du substrat.

FIG. 2

# Description

Le domaine de l'invention se rapporte aux dispositifs d'émission lumineuse pour véhicule automobile, et notamment aux dispositifs d'éclairage et/ou signalisation.

De manière connue, un grand nombre de ces dispositifs comprend un module d'émission lumineuse pourvu d'une pluralité d'éléments électroluminescents formant le coeur d'émission de lumière du dispositif.

Dans certaines applications, notamment pour les dispositifs de signalisation, les dispositifs présentent un profil galbé, c'est-à-dire courbe, de façon à épouser la forme de la carrosserie au niveau de laquelle ils sont reçus.

Cette configuration géométrique se traduit par de nombreuses contraintes sur le design des dispositifs.

En effet, outre des considérations d'homogénéité du rendu lumineux obtenu qui doit se traduire par une difficulté voire une impossibilité pour l'observateur de distinguer les éléments électroluminescents de manière unitaire en son sein, ce type de dispositifs est sujet à des réglementations qui imposent notamment au dispositif de présenter une distribution spatiale d'intensité lumineuse donnée, au sein de laquelle pour au moins certaines directions, l'intensité lumineuse émise par le dispositif présente une valeur supérieure à une valeur minimale prédéterminée et/ou inférieure à une valeur maximale prédéterminée.

Or l'obtention d'un dispositif à la fois galbé et présentant cette propriété n'est pas aisée.

Une solution couramment employée pour parvenir à ce résultat consiste à disposer d'un substrat recevant les éléments électroluminescents se présentant sous la forme d'une pluralité de plaques planes disjointes les unes des autres et orientées sensiblement orthogonalement à la direction d'émission privilégiée envisagée.

Cette solution présente elle-même des inconvénients, notamment en termes de compacité et de complexité. En effet, du fait du galbe du dispositif, ces plaques doivent présenter un agencement relatif en escalier, qui se traduit par un volume occupé important et par la présence de nombreux éléments de connexion et de fixation des plaques au sein du dispositif, outre d'éventuels phénomènes de masquage des éléments électroluminescents par les substrats voisins.

En pratique, ceci rend cette solution difficilement applicable dans certains cas, voire inutilisable.

Aussi, l'invention vise à proposer un module d'émission lumineuse et un dispositif d'émission lumineuse ne présentant pas ces inconvénients.

A cet effet, l'invention concerne un module d'émission lumineuse, notamment pour véhicule automobile, comprenant :

- un substrat comprenant une portion principale courbe s'étendant selon une direction longitudinale,

- une pluralité d'éléments électroluminescents agencés sur le substrat et configurés pour émettre des rayons lumineux lorsqu'alimentés en énergie électrique, et

- un ensemble de commande adapté pour réguler l'énergie électrique fournie aux éléments électroluminescents, l'ensemble de commande présentant un mode de fonctionnement dans lequel l'ensemble de commande est configuré pour la fourniture aux éléments électroluminescents d'énergies et/ou puissances électriques respectives déterminées au moins en fonction de directions principales d'émission lumineuse respectives des éléments électroluminescents pour l'obtention d'au moins deux intensités lumineuses maximales émises par les éléments électroluminescentes selon la direction principale d'émission correspondante qui sont différentes le long de ladite direction longitudinale du substrat.

Selon un aspect de l'invention, dans ledit mode de fonctionnement, l'ensemble de commande est configuré pour réguler l'intensité du courant électrique fourni aux éléments électroluminescents pour l'obtention desdits intensités lumineuses maximales différentes.

Selon un aspect de l'invention, le substrat comporte en outre une pluralité de languettes s'étendant à partir de la portion principale, les languettes étant distribuées le long de la direction longitudinale.

Selon un aspect de l'invention, les languettes sont sensiblement planes.

Selon un aspect de l'invention, les éléments électroluminescents sont agencés sur les languettes, les éléments électroluminescents agencés sur une languette donnée formant un groupe d'éléments électroluminescents.

Selon un aspect de l'invention, dans le mode de fonctionnement, l'ensemble de commande est configuré pour réguler l'énergie électrique fournie aux éléments électroluminescents pour l'obtention d'intensités lumineuses maximales fournies par les éléments électroluminescents sensiblement identiques au sein d'un groupe donné.

Selon un aspect de l'invention, au moins deux éléments électroluminescents présentent des caractéristiques de fonctionnement différentes de sorte que les intensités lumineuses maximales respectivement émises par lesdits deux éléments électroluminescents sont différentes à puissance électrique fournie donnée, l'énergie électrique fournie à un élément électroluminescent donnée étant déterminée également à partir des caractéristiques de fonctionnement dudit élément électroluminescent.

Selon un aspect de l'invention, dans ledit mode de fonctionnement, pour au moins une partie de la longueur du substrat selon ledit axe longitudinal, l'ensemble de commande est configuré pour réguler l'énergie et/ou la puissance électrique fournie aux éléments électroluminescents de sorte que les intensités lumineuses respectives des éléments électroluminescents aillent croissantes selon un sens de parcours donné de ladite partie de la longueur du substrat.

Selon un aspect de l'invention, l'ensemble de commande comprend une pluralité de modules de commande respectivement associés à au moins un élément électroluminescent et respectivement configurés pour réguler l'énergie et/ou la puissance électrique fournie au ou aux éléments électroluminescents associés.

Selon un aspect de l'invention, les modules de commande sont agencés au contact du substrat et sont distribués le long du substrat.

Selon un aspect de l'invention, pour au moins une partie des éléments électroluminescents, chaque élément électroluminescent de ladite partie présente une direction principale d'émission lumineuse décalée angulairement d'une normale au substrat au niveau d'une zone dudit substrat recevant l'élément électroluminescent considéré.

Selon un aspect de l'invention, tout ou partie des éléments électroluminescents de ladite partie présente une direction principale d'émission lumineuse sensiblement parallèle à un plan local tangentiel au substrat au niveau de ladite zone recevant l'élément électroluminescent considéré.

Selon un aspect de l'invention, le module d'émission lumineuse comprend en outre un écran de diffusion agencé en regard des éléments électroluminescents et prévu pour former une surface éclairée à partir des rayons lumineux émis par les éléments électroluminescents.

Selon un aspect de l'invention, l'écran de diffusion, le substrat et les éléments électroluminescents sont configurés pour que ladite surface éclairée soit sensiblement homogène.

L'invention concerne en outre un dispositif d'éclairage et/ou signalisation de véhicule automobile, comprenant un module d'émission lumineuse tel que défini ci-dessus.

Selon un aspect de l'invention, le véhicule s'étend selon un axe, l'ensemble de commande étant configuré pour, dans ledit mode de fonctionnement, réguler l'énergie et/ou la puissance électrique fournie auxdits éléments électroluminescents de sorte que le dispositif d'éclairage et/ou signalisation présente une distribution spatiale d'intensité lumineuse présentant, pour une pluralité de directions, une intensité lumineuse émise selon chacune desdites directions présentant une valeur supérieure à une valeur minimale prédéterminée et/ou une valeur inférieure à une valeur maximale prédéterminée.

Selon un aspect de l'invention, le véhicule s'étendant selon un axe, l'ensemble de commande étant configuré pour, dans ledit mode de fonctionnement, réguler l'énergie et/ou la puissance électrique fournie auxdits éléments électroluminescents de sorte que l'intensité lumineuse maximale respectivement émise par tout ou partie des éléments électroluminescents soit d'autant plus grande que l'angle formé entre la direction principale d'émission de l'élément électroluminescent considéré et l'axe du véhicule est petit.

L'invention sera mieux comprise à la lecture de la description détaillée qui va suivre, donnée uniquement à titre d'exemple et faite en référence aux Figures annexées, sur lesquelles :

- Les Figures 1a et 1b sont des illustrations schématiques d'un dispositif d'émission lumineuse selon l'invention ;
- La Figure 2 illustre une vue de face d'une partie d'un module d'émission lumineuse du dispositif de la Figure 1 ;
- La Figure 3 illustre une vue du dessus d'une partie du module d'émission lumineuse selon l'invention ; et
- La Figure 4 illustre un écran de diffusion d'un module d'émission lumineuse selon l'invention.

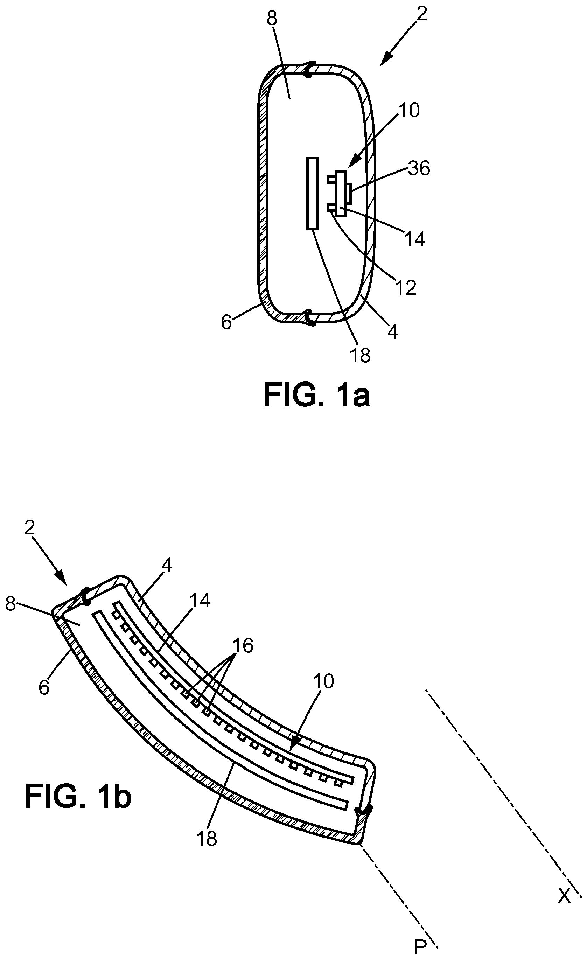

Les Figures 1a et 1b illustrent un dispositif 2 d'émission lumineuse selon l'invention, ci-après dispositif 2.

Le dispositif 2 est configuré pour émettre de la lumière.

Dans le cadre de l'invention, le dispositif 2 est avantageusement destiné à être intégré à un véhicule automobile. Autrement dit, il s'agit d'un dispositif d'émission lumineuse de véhicule automobile.

Avantageusement, le dispositif 2 est un dispositif d'éclairage et/ou de signalisation de véhicule automobile.

Il est par exemple configuré pour mettre en oeuvre une ou plusieurs fonctions photométriques.

Une fonction photométrique est par exemple une fonction d'éclairage et/ou signalisation visible pour un oeil humain. On remarque que ces fonctions photométriques peuvent faire l'objet d'une ou plusieurs règlementations établissant des exigences de colorimétrie, d'intensité, de répartition spatiale selon une grille dite photométrique, ou encore de plages de visibilité de la lumière émise.

Le dispositif 2 est par exemple un dispositif d'éclairage et constitue alors un projecteur - ou phare - de véhicule destiné à être agencé à l'avant du véhicule. Il est alors configuré pour mettre en oeuvre une ou plusieurs fonctions photométriques par exemple choisie(s) parmi une fonction de feux de croisement dite « fonction code », une fonction de feux de route dite « fonction route », une fonction antibrouillard.

Alternativement ou parallèlement, le dispositif est un dispositif de signalisation destiné à être agencé à l'avant ou à l'arrière du véhicule.

Lorsqu'il est destiné à être agencé à l'avant, les fonctions photométriques qu'il est configuré pour mettre en oeuvre (éventuellement en sus de celle(s) qu'il met en oeuvre en sa qualité de dispositif d'éclairage) incluent une fonction d'indication de changement de direction, une fonction d'éclairage diurne connue sous l'acronyme anglophone DRL, pour « Daytime Running Light », une fonction de feu de position, une fonction de signature lumineuse avant, une fonction dite « Side-Marker », qui peut être traduit par signalisation latérale.

Lorsqu'il est destiné à être agencé à l'arrière, ces fonctions photométriques incluent une fonction d'indication de recul, une fonction stop, une fonction antibrouillard, une fonction d'indication de changement de direction, une fonction de signature lumineuse arrière, une fonction lanterne, une fonction « Side-Marker ».

Alternativement, le dispositif 2 est prévu pour l'éclairage de l'habitacle d'un véhicule et est alors destiné à émettre de la lumière principalement dans l'habitacle du véhicule.

Dans ce qui suit, le dispositif 2 est décrit de manière non limitative dans une configuration dans laquelle il est destiné à émettre de la lumière à l'extérieur du véhicule et est un dispositif de signalisation arrière.

En référence aux Figures 1a et 1b, le dispositif 2 comprend un boîtier 4 et une glace de fermeture 6 coopérant l'un avec l'autre pour délimiter intérieurement une cavité 8. Le dispositif 2 comprend en outre un module d'émission lumineuse 10 selon l'invention, ci-après module 10.

Dans le contexte de l'invention, le dispositif 2 est galbé, ou courbe. Autrement dit, vue du dessus, au moins la glace 6 est courbe, ici pour épouser la forme de la carrosserie du véhicule au niveau de la région à laquelle le dispositif 2 est destiné à être agencé. La portion la plus à gauche du dispositif en Figure 1b est par exemple destinée à être agencée du côté extérieur du véhicule, la partie droite étant à l'inverse orientée vers un plan médian du véhicule.

Le module 10 est agencé en tout ou partie dans la cavité 8. Dans certaines réalisations, le dispositif 2 comprend optionnellement un logement de réception pour la réception du module 10. Ce logement est par exemple agencé dans le boîtier 4. Ce boîtier est avantageusement clos. Il est par exemple défini par une enveloppe formant une portion arrière de ce logement, et par un écran de diffusion décrit ci-après ou un élément sur lequel l'écran de diffusion est formé, qui coopère avec ladite enveloppe. Les parois internes de ce logement autres que l'écran sont par exemple réfléchissantes et/ou diffusantes pour la lumière émise par le module 10 qui leur parvient (l'écran étant diffusant mais non réfléchissant, comme décrit ci-après).

Le module 10 est configuré pour émettre de la lumière. Avantageusement, comme dans l'exemple des Figures 1a et 1b, il est agencé pour émettre de la lumière en direction de la glace de fermeture (qui est transparente pour au moins une partie de cette lumière émise par le module 10).

Dans le contexte de l'invention, le dispositif 2 est configuré pour présenter une distribution spatiale d'intensité lumineuse présentant, pour au moins une pluralité de directions données, des valeurs minimales et/ou maximales. Autrement dit, selon ces directions, l'intensité lumineuse émise par le dispositif 2 doit être supérieure et/ou inférieure à une valeur seuil prédéterminée (cette ou ces valeurs sont par exemple définies pour chaque direction considérée). Les valeurs seuils sont par exemple définies par une ou plusieurs réglementations. Une telle direction P est illustrée en Figure 1b, et est par exemple une direction horizontale (au sens de l'orientation du dispositif 2 au sein du véhicule) parallèle à un axe de déplacement X (horizontal) du véhicule selon lequel le véhicule s'étend et selon lequel l'intensité lumineuse émise par le dispositif 2 doit être supérieure à une valeur seuil donnée. Cette direction P peut être vue comme une direction d'émission privilégiée (parmi une pluralité).

Ces considérations de distribution d'intensité se traduisent par des contraintes fortes sur le module 10 en termes d'intensité lumineuse émise en fonction de la direction considérée.

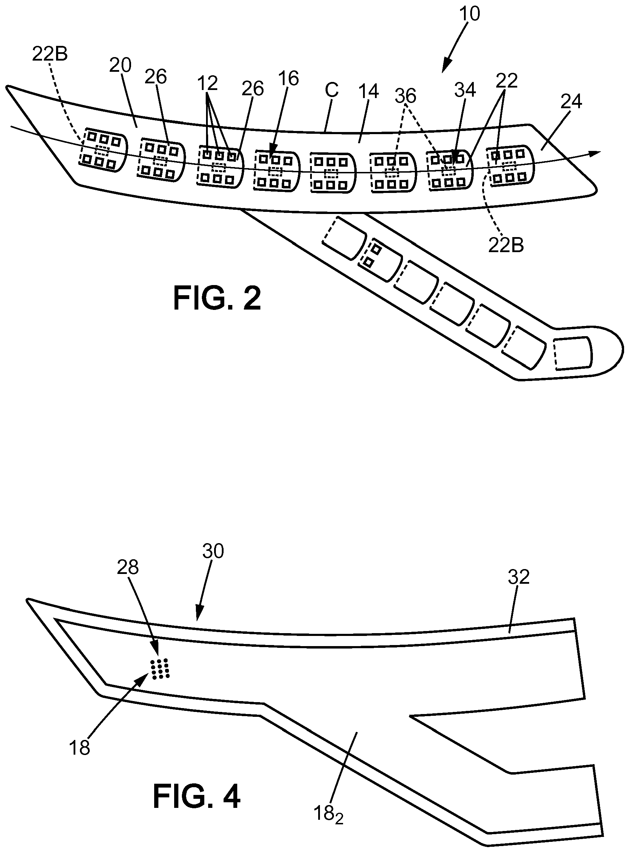

En référence aux Figures 1a, 1b et 2, le module 10 comprend un substrat 14, des éléments électroluminescents 16 et un écran 18.

Le substrat 14 forme un support pour les éléments électroluminescents 16.

En outre, il est configuré pour acheminer de l'énergie électrique aux éléments électroluminescents 16 pour la génération de rayons lumineux par ceux-ci. A cet effet, il comprend des moyens d'acheminement d'énergie électrique configurés pour le raccordement des éléments 16 à une source d'énergie électrique. Ces moyens comprennent par exemple des éléments de connexion en métal ou métallisés, tels que des pistes en cuivre ou des fils.

On remarque que la Figure 2 illustre deux substrats 14 agencés au contact l'un de l'autre. Ils peuvent être vus comme appartenant à des modules 10 distincts que comprend le dispositif 2. Dans cette configuration, les écrans 18 respectifs des modules 10 sont par exemple formés sur une même pièce. Comme également illustré sur cette Figure, le substrat 14 est agencé sensiblement horizontalement par rapport à l'orientation du véhicule (substrat supérieur), ou bien est incliné par rapport à l'horizontale (substrat inférieur).

Le substrat 14 présente une forme générale polygonale, telle que rectangulaire. Il s'étend selon une direction, ou trajet, longitudinale D. Cette direction ou trajet peut être courbe, par exemple pour rendre compte d'un galbe du substrat et/ou bien pour tenir compte de la configuration géométrique du substrat, dont la forme est optionnellement courbe, par exemple coudée (comme illustré pour le substrat inférieur en Figure 2). Cette courbure est par exemple le résultat d'une flexion du substrat (ou d'une portion du substrat).

Le substrat 14 présente un contour C ayant des bords rectilignes ou non.

Le substrat 14 comprend une portion principale 20 et des languettes 22.

La portion principale 20 est délimitée extérieurement par le contour C et confère au substrat 14 son allure générale. Elle se présente sous la forme générale d'une plaque polygonale, telle que rectangulaire dont l'épaisseur est petite relativement à ses autres dimensions. Ses angles sont optionnellement arrondis.

La portion 20 est formée par l'intégralité du substrat à l'exception des languettes 22 décrites-ci-après.

Avantageusement, la portion principale 20 est souple. Plus spécifiquement, elle est adaptée pour se déformer élastiquement, en particulier sous l'effet d'un effort de flexion, tel qu'une flexion tendant à rapprocher ses extrémités longitudinales l'une de l'autre et appliquée normalement à une face du substrat.

Ceci permet notamment à la portion principale et au substrat d'être galbés, notamment pour être agencés sensiblement parallèlement à la glace de fermeture 6 et/ou à la paroi arrière du boîtier 4 lorsque le dispositif 2 est galbé. Autrement dit, la portion principale présente avantageusement un galbe, par exemple identique à celui de la glace de fermeture et/ou à celui de l'écran 18 sur tout ou partie de sa longueur.

Les languettes 22 se présentent sous la forme de langues de matière. Elles s'étendent à partir de la portion principale. Plus spécifiquement, elles s'étendent chacune à partir d'un bord interne de la portion principale. Autrement dit, elles ne s'étendent pas à partir d'un bord externe du substrat 14, c'est-à-dire du bord tourné vers l'extérieur du substrat 14.

Ces languettes sont par exemple formées par découpe du substrat, qui présente initialement une surface pleine.

Les languettes 22 sont connectées à la portion principale 20 par un bord 22B de connexion (en pointillés sur certaines languettes de la Figure 2), et leurs autres bords sont libres, c'est-à-dire disjoints du substrat 14. Le bord de connexion 22B est par exemple venu de matière avec la portion principale. Avantageusement, les languettes présentent une forme générale polygonale, telle que rectangulaire, dont tout ou partie des angles est optionnellement arrondie. Le bord de connexion 22B correspond à au moins un côté de ce polygone, les autres côtés formant des bords libres.

Avantageusement, elles ont des dimensions sensiblement identiques, au moins pour une partie d'entre elles. On remarque que pour des raisons d'encombrement ou de forme du substrat, les languettes d'extrémité peuvent être amenées à avoir des dimensions voire une forme différente de celles des languettes qui ne sont pas proximales relativement aux extrémités du substrat.

Les languettes 22 sont sensiblement planes. En outre, avantageusement, elles sont agencées pour demeurer sensiblement plane en cas de fléchissement élastique de la portion principale.

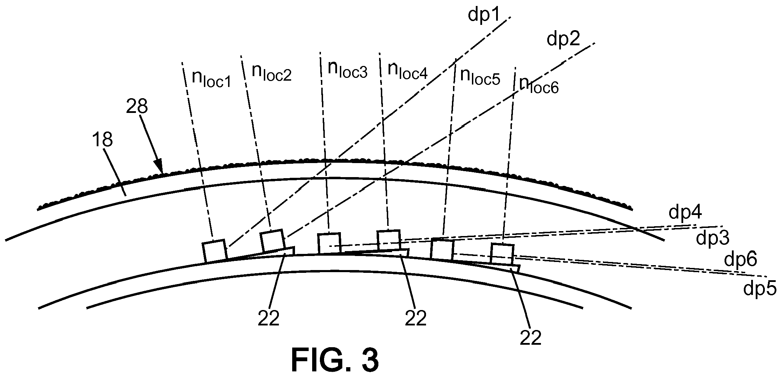

La Figure 3 illustre la configuration géométrique des languettes dans une telle configuration fléchie. Dans cette configuration, les languettes s'étendent sensiblement dans un plan tangent localement à la portion principale.

Les languettes sont avantageusement réalisées à partir du même matériau que le reste du substrat 14. Leur planéité, notamment en configuration fléchie de la portion principale, a pour effet de limiter les transmissions d'efforts de flexion imprimés à la portion principale aux composants agencés sur les languettes et/ou aux soudures rendant lesdits composants solidaires de la surface desdites languettes,.

Le substrat 14 comprend par exemple une pluralité de languettes 22 agencées consécutivement le long du substrat. Elles sont par exemple ainsi agencées de manière alignée le long d'une direction longitudinale du substrat.

Elles présentent par exemple une même orientation spatiale. Par exemple, comme illustré en Figure 2, leur bord de connexion 22B forme une extrémité longitudinale des languettes proximale relativement à une même extrémité du substrat, le bord opposé étant tourné vers la languette 22 venant après dans le sens du parcours du substrat depuis cette extrémité vers l'autre extrémité.

Préférentiellement, le bord de connexion 22B des languettes est sensiblement parallèle à l'axe de courbure locale du substrat. De la sorte, les languettes ne sont que peu voire pas mécaniquement contraintes par l'effort de flexion du substrat 14.

On remarque que le substrat peut comprendre une ligne de languettes comme illustré en Figure 2, ou bien une pluralité de lignes de languettes s'étendant parallèlement les unes aux autres et décalés les unes des autres transversalement à cette direction longitudinale.

Le substrat est par exemple réalisé à partir d'un composite de résine époxy renforcée, typiquement avec des fibres de verre. Par exemple, il est réalisé à partir d'un matériau couramment appelé PCB FR-4 (PCB étant l'acronyme anglophone de Printed Circuit Board, qui signifie circuit imprimé).

Il présente avantageusement une épaisseur comprise entre 0,3 mm et 1,6 mm. Cette configuration, combinée à la présence d'ouvertures (le contour des languettes) réalisées dans la surface du substrat, permet de favoriser la souplesse du substrat et permet de se dispenser de matériaux onéreux couramment utilisés pour former des substrats flexibles.

Comme décrit ci-après, les éléments électroluminescents 16 sont agencés sur une face 24 donnée du substrat. Avantageusement, cette face 24 est adaptée pour réfléchir au moins une partie de la lumière issue des éléments 16 et leur parvenant.

Par exemple, à cet effet, cette face est blanche.

Avantageusement ou parallèlement, cette face 24 est en outre configurée pour diffuser au moins partie de la lumière issue des éléments 16 et lui parvenant.

Par exemple, à cet effet, elle présente des aspérités adaptées.

Les éléments électroluminescents 16 sont chacun configurés pour émettre de la lumière lorsqu'alimentés en énergie électrique de manière appropriée. Ces éléments 16 forment le coeur d'émission de lumière du module 10.

Avantageusement, ces éléments 16 sont des éléments électroluminescents à semi-conducteur adaptés pour générer des photons par électroluminescence. Avantageusement, chaque élément 16 d'au moins une partie des éléments 16 que comprend le module 10 est formé à partir d'une diode électroluminescente. Par exemple, tous le sont. On entend ici « formé à partir de » que la structure photoémettrice que l'élément 16 comprend est une diode électroluminescente, parfois par appelée puce de DEL.

Avantageusement, dans certaines réalisations, au moins une partie des éléments électroluminescents 16 comprend une diode et un boîtier 26 au sein duquel la diode correspondante est agencée. Les boîtiers 26 sont parfois appelés « packages », qui vient de l'anglais et peut être traduit par boîtier.

L'agencement de la diode au sein du boitier est choisi pour obtenir une direction principale d'émission de la diode correspondante qui est choisie à orientation donnée du boîtier 26 associé. Cette direction principale correspond à la direction selon laquelle l'élément 16 considéré émet une intensité lumineuse maximale.

Les éléments électroluminescents 16 sont agencés sur le substrat. Comme indiqué précédemment, ils sont agencés sur une même face 24 du substrat. Cette face 24 est tournée vers l'écran 18 et la glace de fermeture 6.

A cet effet, les boîtiers 26 sont fixés sur la face 24.

Dans le contexte de l'invention, les éléments électroluminescents sont avantageusement agencés sur les languettes 22 du substrat. Par exemple, ils sont agencés sur celles-ci à raison de deux ou plus de deux par languette, par exemple à raison de 4, 6, 8, 10 ou plus par languette. Les éléments 16 agencés sur une languette donnée forment un groupe d'éléments électroluminescents.

Les éléments 16 sont avantageusement agencés en une ou plusieurs lignes sur le substrat. Ces lignes sont avantageusement chacune parallèle à la direction longitudinale D du substrat (qui peut être incurvée en fonction de la configuration du substrat 14 considérée).

Dans l'exemple des Figures, les éléments 16 sont ainsi agencés en deux lignes parallèles.

Avantageusement, la distance séparant deux éléments 16 consécutifs le long du substrat est sensiblement constante.

Avantageusement, pour au moins une partie des éléments 16, chaque élément 16 est associé à au moins un élément 16 se trouvant sensiblement au même emplacement long du substrat. Autrement dit, les éléments électroluminescents correspondants sont également agencés en colonnes comprenant chacune au moins deux éléments 16.

Avantageusement, pour au moins une partie des éléments 16, les éléments 16 sont configurés pour présenter une direction principale d'émission décalée angulairement de la direction normale au substrat au niveau de la zone du substrat portant l'élément 16 considéré. Autrement dit, cette direction ne correspond pas à la normale locale au substrat.

Par exemple, les éléments 16 sont configurés pour émettre de la lumière selon une direction principale privilégiée comprise angulairement entre un plan parallèle à un plan local tangentiel à la zone du substrat correspondante et la normale locale au substrat.

De manière avantageuse, les éléments 16 correspondants sont configurés pour émettre de la lumière selon une direction privilégiée comprise dans un plan sensiblement parallèle au plan local tangentiel à la zone du substrat correspondante. Autrement dit, comme illustré en Figure 3, les éléments électroluminescents sont configurés pour que cette direction soit parallèle à la languette 22 sur laquelle ils se trouvent.

Les éléments 16 correspondants sont par exemple des diodes électroluminescentes connues sous le nom anglophone de « Side-LED », qui peut être traduit par « DEL de côté ».

En pratique, la direction principale souhaitée est obtenue en agençant la diode au sein du boîtier 26 correspondant de manière appropriée.

On remarque que ces configurations peuvent être combinées, le module 10 comprenant des éléments 16 parallèlement au plan tangentiel local au substrat considéré et/ou d'autres émettant angulairement entre le plan parallèle au plan tangentiel local et la normale à la zone considérée.

On remarque en outre qu'alternativement ou parallèlement à la présence des éléments électroluminescents ayant une direction principale d'émission telle que ci-dessus, le module 10 peut comprendre des éléments électroluminescents dont la direction principale correspond sensiblement à la normale locale au substrat.

Sur la Figure 3, les directions principales orientées parallèlement au plan local tangentiel ont les références dp3 à dp6 et les normales locales associées sont de références $n_{loc3}$ à $n_{loc6}$. Les directions principales ayant une configuration simplement inclinée vis-à-vis de la normale correspondante autre sont référencées dp1 et dp2 (les normales locales associées sont de référence $n_{loc1}$ et $n_{loc2}$).

Dans certaines réalisations, le module 10 comprend uniquement des éléments 16 ayant une direction principale parallèle au plan tangentiel local.

Le module 10 est par exemple configurés pour émettre de la lumière de couleur blanche, ou encore rouge ou ambre. D'autres couleurs sont envisageables en fonction de l'application visée.

On remarque que le module 10 peut comprendre des éléments 16 configurés pour émettre de la lumière de couleur blanche, d'autres de couleur ambre et/ou d'autres de couleur rouge.

Les éléments 16 présentent chacun des propriétés de fonctionnement qui définissent, pour une énergie électrique ou une puissance électrique reçue donnée, l'intensité lumineuse et la couleur qu'ils fournissent.

En pratique, de manière connue, ces propriétés de fonctionnement ne sont pas finement maîtrisables lors de la fabrication des éléments électroluminescents, de sorte que des diodes ayant une même référence produit, par exemple une référence de fournisseur, peuvent toutefois présenter au moins des intensités lumineuses données substantiellement différents l'une de l'autre à puissance électrique donnée.

Cet aspect est à l'origine du procédé dit de « binning » (qui vient de l'anglais et peut être traduit par tri final), qui est un tri des éléments produits en fonction de leurs propriétés de fonctionnement en différentes catégories, ou « bins », au sein desquelles les éléments ont des propriétés de fonctionnement proches. Il est ainsi possible de se procurer des éléments 16 possédant des propriétés de fonctionnement proches, voire sensiblement identiques.

Dans le contexte de l'invention, avantageusement, au moins une partie des éléments 16 présente des propriétés de fonctionnement distinctes à énergie électrique ou puissance électrique donnée. Ceci permet de minimiser le coût du dispositif 2, l'emploi de seuls éléments appartenant à un bin donné étant plus onéreux.

L'écran 18 est configuré pour présenter une surface éclairée à partir de la lumière émise par les éléments 16. En outre, il est configuré pour diffuser au moins une partie de la lumière reçue des éléments photoémissifs et passant par lui.

Préférentiellement, conjointement au substrat 14 et aux éléments photoémissifs, l'écran est configuré pour présenter une surface éclairée sensiblement homogène. Par homogène, on entend que les éléments photoémissifs ne sont pas distinguables à l'oeil nu au sein de cette surface éclairée par un observateur dont le regard est dirigé vers l'écran.

En pratique, cette propriété résulte -toute chose étant égale par ailleurs - de la combinaison de la densité de distribution des éléments photoémissifs sur le substrat et de la distance entre le substrat et l'écran.

Avantageusement, à cet effet, pour au moins une partie des éléments photoémissifs et avantageusement pour tous, la distance entre deux éléments photoémissifs adjacents est inférieure ou égale à la distance qui les sépare de l'écran, et avantageusement inférieure à 70% de cette dernière.

On remarque que l'homogénéité peut être quantifiée.

Par exemple, en la notant H, elle peut être déterminée à partir de ou en tant que minimum entre d'une part une uniformité locale L_U et une uniformité globale G_U.

L'uniformité globale est par exemple déterminée à partir de la relation :

$$G\_U = 100 * \left(1 - \frac{\sigma(L_{ROI})}{Moy(L_{ROI})}\right)$$

où ROI désigne la surface éclairée présentée par l'écran et $L_{ROI}$ désigne la luminance de la surface éclairée ($\sigma$ désigne l'écart-type et Moy la moyenne).

L'uniformité locale est par exemple déterminée comme suit. On considère un pixel X de la surface éclairée, la région carrée de côté n (par exemple n pixels) centrée sur X, ainsi que 8 régions adjacentes carrées de côté n, ces régions étant respectivement centrées sur des pixels $X_i$ se trouvant chacun à une distance n du point X. Les points Xi sont par exemple régulièrement distribués autour de X.

On définit le contraste local l_c en fonction de n selon la relation

$$l\_c(n) = max_{\forall X \in ROI}\left(max_{i=1,\dots,8}\left(\frac{|M-Mi|}{|M+Mi|}\right)\right), \text{ où}$$

M et Mi sont les luminances moyennes des pixels de la région centrée sur X, sur le Xi considéré respectivement.

On détermine la grandeur MSlocal_contrast en tant que maximum des contrastes locaux l_c(n) pour n=2p+1, avec p allant de 1 à 20, et on détermine la grandeur L_U selon la relation L_U=100(1-2MSlocal_contrast).

On remarque que dans certaines réalisations dans lesquelles le dispositif 2 comprend deux zones relativement distinctes, l'homogénéité globale est par exemple déterminée en tant que minimum des homogénéités respectives des deux régions.

En outre, on pourra la déterminer en tant que combinaison linéaire (ou alternativement, en tant que minimum) de l'homogénéité considérée selon divers axes.

Aussi, dans le cadre de l'invention, l'homogénéité H est avantageusement supérieure à 85%.

On remarque que l'écran 18 est au moins en partie transparent à la lumière des éléments 16.

Plusieurs configurations sont envisagées pour obtenir l'effet diffusant de l'écran 18.

Dans une première configuration, l'écran 18 est dit diffusant « dans la masse ». Autrement dit, il est réalisé à partir d'un matériau diffusant. Ce type de matériau est parfois appelé opalescent.

Alternativement, l'écran présente une surface pourvue de microstructures 28 prévues pour diffuser la lumière des éléments photoémissifs. Elles sont avantageusement prévues pour diffuser la lumière par diffraction en transmission.

Ces microstructures 28 sont par exemple ménagées dans la surface de la face externe de l'écran, c'est-à-dire de la face tournée vers la glace de fermeture. Elles sont présentes sur l'intégralité de la surface de l'écran (elles sont illustrées sur seulement une partie de l'écran 18 en Figure 4 par souci de clarté).

Avantageusement, les microstructures 28 sont obtenues par injection.

Ces microstructures se présentent par exemple sous la forme de dépressions ou de saillies ménagées dans la surface de la face de l'écran. Elles présentent des dimensions caractéristiques d'un ordre de grandeur compris entre celui de la longueur d'onde de la lumière émise par les éléments 16 et 100 fois cette dernière.

L'écran 18 présente une forme générale polygonale, telle que rectangulaire. Il présente par exemple une forme de bande. Ses angles sont optionnellement arrondis.

L'écran est agencé en regard de la face du substrat 14 portant les éléments photoémissifs 16. Il se situe à l'écart de cette face et des éléments photoémissifs.

L'écran se situe à une distance du substrat par exemple comprise entre 20 mm et 90 mm.

Avantageusement, l'écran 18 est galbé. Préférentiellement, il présente un galbe identique à celui du substrat sur au moins une partie de sa longueur. Autrement dit, l'écran, ou plus spécifiquement sa face portant les microstructures, est agencée de manière sensiblement parallèle à au moins une partie de la portion principale du substrat (c'est-à-dire de la grande face de celui-ci tournée vers l'écran). De la sorte, pour au moins une partie des éléments 16, tous les éléments photoémissifs considérés se trouvent tous sensiblement à la même distance de l'écran 18.

On remarque qu'optionnellement, comme illustré en Figure 4, l'écran 18 est porté par un élément 30 appartenant au module 10. Outre l'écran 18, cet élément 30 comprend une portion de fixation 32 entourant l'écran sur au moins une partie de son pourtour. Cette portion 32 est prévue pour la fixation de l'élément 30 au sein du volume 8, et optionnellement au sein du logement 12, ainsi que pour la préhension de l'élément 30.

On remarque que l'élément 30 peut comprendre plusieurs écrans, comme illustré en Figure 4. Sur cette Figure, il comprend un premier écran sensiblement horizontal et un deuxième écran $18_2$ de forme coudée s'étendant à partir du premier de manière inclinée par rapport à l'horizontale.

Dans le contexte de l'invention, outre les éléments décrits ci-dessus, le module 10 comprend en outre un ensemble de commande 34 pour la commande des éléments électroluminescents 16.

L'ensemble de commande 34 est configuré pour réguler l'énergie électrique et/ou la puissance électrique fournie aux éléments 16 pour réaliser leur allumage et leur extinction et pour commander l'intensité lumineuse émise par chacun d'entre eux.

L'ensemble de commande 34 comprend avantageusement une pluralité de modules de commande 36 distribués le long du substrat. Chaque module est couplé à une pluralité d'éléments 16 pour la commande de ceux-ci.

Par exemple, un module de commande donné est associé aux éléments 16 agencés sur une languette donnée. Le module de commande se situe par exemple sur la languette elle-même, par exemple sur la face opposée à la face 24, ou aux abords de la languette sur la portion principale 20.

Ces modules comprennent par exemple un microcontrôleur programmable, tel qu'un circuit intégré de type ASIC, pour « application-specific integrated circuit », qui signifie circuit intégré spécifique à une application, ou un régulateur intégré, ou un régulateur réalisé au moyen de composants discrets..

Selon l'invention, l'ensemble de commande 34 présente un mode de fonctionnement dans lequel il est configuré pour commander la fourniture aux éléments électroluminescents d'énergies (ou puissances) électriques respectives déterminées au moins en fonction de la direction principale d'émission des éléments électroluminescents pour l'obtention d'au moins deux intensités lumineuses maximales émises par les éléments électroluminescentes selon la direction principale correspondante qui sont différentes.

Ici, on entend que ce mode de fonctionnement constitue un véritable mode de fonctionnement intentionnel du dispositif et pouvant être maintenu dans le temps, et pas simplement un état transitoire du dispositif, par exemple lors de sa mise en marche.

En outre, dans ce mode de fonctionnement, les éléments 16 considérés sont maintenus allumés. Ce mode de fonctionnement est avantageusement sélectivement activable et désactivable.

A cet effet, avantageusement, l'ensemble de commande 34 est configuré pour mettre en oeuvre cette fonctionnalité en commandant l'intensité du courant électrique fourni aux éléments 16. Autrement dit, ces intensités lumineuses différentes résultent au moins de la régulation du courant fourni aux éléments 16 par l'ensemble 34.

Avantageusement, dans ce mode de fonctionnement, pour au moins une partie des éléments 16, l'ensemble de commande 34 est configuré pour la fourniture aux éléments 16 considérés de puissances électriques respectives se traduisant par une intensité lumineuse maximale émise d'autant plus importante que l'écart angulaire entre la direction principale d'émission du module considéré et l'axe X du véhicule est faible. Autrement dit, plus la direction d'émission d'un élément 16 parmi ceux considérés est proche de l'axe X, plus l'intensité lumineuse maximale au niveau de laquelle son émission est commandée par l'ensemble 34 est élevée. Ceci permet de faciliter l'obtention d'une distribution d'intensité conforme aux exigences réglementaires dans des configurations où ce serait impossible si toutes les sources étaient commandées de manière à présenter toutes la même intensité lumineuse.

Dans une réalisation telle celle des Figures, pour au moins une portion de la longueur du substrat, ceci se traduit par une intensité lumineuse maximale des éléments 16 allant croissante le long de la direction longitudinale D parcourue depuis une extrémité de ladite portion à l'autre.

De façon générale, avantageusement, dans certains réalisations, l'ensemble de commande 34 est configuré pour commander les éléments 16 pour que l'intensité lumineuse émise par ceux-ci soit croissante d'un élément à l'élément consécutif et/ou du moins d'une languette à une autre, selon un sens de parcours du substrat sur au moins une portion du substrat. Préférentiellement, les niveaux d'intensité lumineuse fournie par les éléments 16 sont définis de sorte que la différence entre deux intensités lumineuses consécutives est suffisamment faible pour être indiscernable à l'oeil humain. Ceci permet d'agir sur la distribution d'intensités lumineuses sans préjudice sur l'homogénéité du système.

On remarque que la puissance électrique déterminée pour un élément 16 donné est déterminée en fonction de ses propriétés de fonctionnement, qui conditionnent notamment l'intensité lumineuse de l'élément 16 à puissance électrique donnée. De ce fait, la configuration exacte de l'ensemble 34 pour l'obtention du premier mode de fonctionnement est fortement variable en fonction de la population d'éléments 16 que comprend le système.

Aussi, pour deux éléments 16 ayant des propriétés de fonctionnement similaires, par exemple deux éléments ayant des références produits identiques et appartenant à une même catégorie ou « bin », l'obtention d'intensités lumineuses maximales distinctes est mise en oeuvre par la fourniture aux éléments d'intensités électriques respectives distinctes. A l'inverse, cette seule différence en intensité du courant électrique peut aboutir à des intensités maximales identiques pour des éléments 16 aux propriétés de fonctionnement différentes.

Avantageusement, dans certaines réalisations, dans le premier mode de fonctionnement, l'ensemble de commande 34 est configuré pour que les éléments 16 agencés sur une languette 22 donnée présentent des intensités lumineuses maximales sensiblement identiques.

Avantageusement, l'ensemble de commande 34 présente au moins un autre mode de fonctionnement sélectivement activable.

Par exemple, il comprend au moins un mode de fonctionnement parmi :

- un mode de fonctionnement dans lequel les puissances électriques fournies aux éléments 16 sont configurées pour que les intensités lumineuses maximales des éléments 16 soient sensiblement identiques, et
- un mode de fonctionnement dans lequel l'ensemble de commande 34 commande aux éléments l'implémentation d'une séquence lumineuse au cours de laquelle tout ou partie des éléments 16 est séquentiellement et/ou simultanément allumée et/ou éteinte.

Par exemple, l'un ou l'autre de ces modes est mis en oeuvre en réponse à la détection d'un évènement se produisant au niveau du véhicule, tel que l'allumage du véhicule, l'ouverture d'une porte qu'il comprend ou bien l'actionnement d'une commande d'indication de changement de direction.

Le fonctionnement du dispositif 2 va maintenant être décrit en référence aux Figures.

Lors de la mise en marche du dispositif 2, l'ensemble de commande 34 commande l'alimentation des éléments 16 en énergie électrique, ce qui se traduit par leur allumage.

Lorsque le mode de fonctionnement décrit ci-dessus est mis en oeuvre, par exemple par défaut, l'ensemble 34 assure la régulation de l'énergie électrique fournie de sorte que les intensités maximales d'au moins deux éléments 16 soient distinctes, et avantageusement en appliquant tout ou partie des schémas d'intensité décrits ci-dessus.

Un autre mode de fonctionnement est par exemple par suite mise en oeuvre, par exemple en réponse à la détection d'un évènement au niveau du véhicule.

L'invention présente plusieurs avantages.

Tout d'abord, il facilite l'obtention d'une distribution d'intensités lumineuses conformes aux exigences réglementaires et ce de manière simple. En particulier, ceci est particulièrement simple lorsque cette disposition résulte d'une commande de l'intensité du courant électrique fourni aux éléments electroluminescents.

Ceci est particulièrement avantageux pour un dispositif 2 galbé, pour lequel l'obtention d'une distribution d'intensités lumineuses conformes aux exigences réglementaires n'est pas aisée à concilier avec un aspect homogène du dispositif.

## Revendications

1. Module d'émission lumineuse, notamment pour véhicule automobile, comprenant :

   - un substrat (14) comprenant une portion principale (20) courbe s'étendant selon une direction longitudinale (D),
   - une pluralité d'éléments electroluminescents (16) agencés sur le substrat et configurés pour émettre des rayons lumineux lorsqu'alimentés en énergie électrique, et
   - un ensemble de commande (34) adapté pour réguler l'énergie électrique fournie aux éléments electroluminescents, l'ensemble de commande présentant un mode de fonctionnement dans lequel l'ensemble de commande est configuré pour la fourniture aux éléments electroluminescents (16) d'énergies et/ou puissances électriques respectives déterminées au moins en fonction de directions principales d'émission lumineuse (dp1, ..., dp6) respectives des éléments electroluminescents pour l'obtention d'au moins deux intensités lumineuses maximales émises par les éléments électroluminescentes selon la direction principale d'émission correspondante qui sont différentes le long de ladite direction longitudinale (D) du substrat.

2. Module d'émission lumineuse selon la revendication 1, dans lequel, dans ledit mode de fonctionnement, l'ensemble de commande (34) est configuré pour réguler l'intensité du courant électrique fourni aux éléments électroluminescents pour l'obtention desdits intensités lumineuses maximales différentes.

3. Module d'émission lumineuse selon la revendication 1 ou 2, dans lequel le substrat comporte en outre une pluralité de languettes (22) s'étendant à partir de la portion principale, les languettes étant distribuées le long de la direction longitudinale.

4. Module d'émission lumineuse selon la revendication 3, dans lequel les languettes sont sensiblement planes.

5. Module d'émission lumineuse selon la revendication 3 ou 4, dans lequel les éléments électroluminescents (16) sont agencés sur les languettes (22), les éléments électroluminescents agencés sur une languette donnée formant un groupe d'éléments électroluminescents.

6. Module d'émission lumineuse selon la revendication 5, dans lequel, dans le mode de fonctionnement, l'ensemble de commande (34) est configuré pour réguler l'énergie électrique fournie aux éléments électroluminescents pour l'obtention d'intensités lumineuses maximales fournies par les éléments électroluminescents sensiblement identiques au sein d'un groupe donné.

7. Module d'émission lumineuse selon l'une quelconque des revendications précédentes, dans lequel au moins deux éléments électroluminescents présentent des caractéristiques de fonctionnement différentes de sorte que les intensités lumineuses maximales respectivement émises par lesdits deux éléments électroluminescents sont différentes à puissance électrique fournie donnée, l'énergie électrique fournie à un élément électroluminescent (16) donné étant déterminée également à partir des caractéristiques de fonctionnement dudit élément électroluminescent (16).

8. Module d'émission lumineuse selon l'une quelconque des revendications précédentes, dans lequel dans ledit mode de fonctionnement, pour au moins une partie de la longueur du substrat selon ledit axe longitudinal, l'ensemble de commande (34) est configuré pour réguler l'énergie et/ou la puissance électrique fournie aux éléments électroluminescents de sorte que les intensités lumineuses respectives des éléments électroluminescents aillent croissantes selon un sens de parcours donné de ladite partie de la longueur du substrat.

9. Module d'émission lumineuse selon l'une quelconque des revendications précédentes, dans lequel l'ensemble de commande (34) comprend une pluralité de modules de commande (36) respectivement associés à au moins un élément électroluminescent et respectivement configurés pour réguler l'énergie et/ou la puissance électrique fournie au ou aux éléments électroluminescents associés.

10. Module d'émission lumineuse selon la revendication 9, dans lequel les modules de commande sont agencés au contact du substrat et sont distribués le long du substrat.

11. Module d'émission lumineuse selon l'une quelconque des revendications précédentes, dans lequel, pour au moins une partie des éléments électroluminescents (16), chaque élément électroluminescent de ladite partie présente une direction principale d'émission lumineuse décalée angulairement d'une normale ($n_{loc1}$, ..., $n_{loc6}$) au substrat au niveau d'une zone dudit substrat recevant l'élément électroluminescent considéré.

12. Module d'émission lumineuse selon la revendication 11, dans lequel tout ou partie des éléments électroluminescents (16) de ladite partie présente une direction principale d'émission lumineuse sensiblement parallèle à un plan local tangentiel au substrat au niveau de ladite zone recevant l'élément électroluminescent considéré.

13. Module d'émission lumineuse selon l'une quelconque des revendications précédentes, comprenant en outre un écran de diffusion (18) agencé en regard des éléments électroluminescents et prévu pour former une surface éclairée à partir des rayons lumineux émis par les éléments électroluminescents.

14. Module d'émission lumineuse selon la revendication 13, dans lequel l'écran de diffusion (18), le substrat (14) et les éléments électroluminescents (16) sont configurés pour que ladite surface éclairée soit sensiblement homogène.

15. Dispositif d'éclairage et/ou signalisation de véhicule automobile, comprenant un module d'émission lumineuse (10) selon l'une quelconque des revendications précédentes.

16. Dispositif d'éclairage et/ou signalisation selon la revendication 15, le véhicule s'étendant selon un axe (X), l'ensemble de commande (34) étant configuré pour, dans ledit mode de fonctionnement, réguler l'énergie et/ou la puissance électrique fournie auxdits éléments électroluminescents (16) de sorte que le dispositif d'éclairage et/ou signalisation présente une distribution spatiale d'intensité lumineuse présentant, pour une pluralité de directions, une intensité lumineuse émise selon chacune desdites directions présentant une valeur supérieure à une valeur minimale prédéterminée et/ou une valeur inférieure à une valeur maximale prédéterminée.

17. Dispositif d'éclairage et/ou signalisation selon la revendication 15 ou 16, le véhicule s'étendant selon un axe (X), l'ensemble de commande (34) étant configuré pour, dans ledit mode de fonctionnement, réguler l'énergie et/ou la puissance électrique fournie auxdits éléments électroluminescents de sorte que l'intensité lumineuse maximale respectivement émise par tout ou partie des éléments électroluminescents (16) soit d'autant plus grande que l'angle formé entre la direction principale d'émission de l'élément électroluminescent considéré et l'axe du véhicule (X) est petit.

FIG. 1a

FIG. 1b

FIG. 2

FIG. 4

EP 3 339 094 A1

**FIG. 3**

Europäisches
Patentamt

European
Patent Office

Office européen
des brevets

**RAPPORT DE RECHERCHE EUROPEENNE**

Numéro de la demande

EP 17 19 0846

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | EP 2 671 756 A2 (LG INNOTEK CO LTD [KR]) 11 décembre 2013 (2013-12-11) | 1,2,7-9, 11-17 | INV. B60Q1/26 |
| Y | * le document en entier * | 3-5 | F21S8/10 H05K1/18 |
| Y | EP 0 531 185 A1 (VALEO VISION [FR]) 10 mars 1993 (1993-03-10) | 3-5 | ADD. |
| A | * colonne 5, ligne 5 - ligne 14 * * figures 2,3 * | 1 | F21Y115/10 |
| A | US 2003/193815 A1 (MISHIMAGI KAZUHARU [JP]) 16 octobre 2003 (2003-10-16) * le document en entier * | 1-17 | |
| A | EP 1 914 116 A2 (ICHIKOH INDUSTRIES LTD [JP]) 23 avril 2008 (2008-04-23) * le document en entier * | 1-17 | |
| A | JP 2011 187331 A (STANLEY ELECTRIC CO LTD) 22 septembre 2011 (2011-09-22) * le document en entier * | 1-17 | |
| A | DE 10 2006 031345 A1 (PATENT TREUHAND GES FUER ELEKTRISCHE GLUEHLAMPEN MBH [DE]) 10 janvier 2008 (2008-01-10) * abrégé; figures 2-4 * | 1-17 | DOMAINES TECHNIQUES RECHERCHES (IPC) B60Q F21S H05K B60R |

Le présent rapport a été établi pour toutes les revendications

| Lieu de la recherche | Date d'achèvement de la recherche | Examinateur |
|---|---|---|
| La Haye | 13 décembre 2017 | Cosnard, Denis |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 17 19 0846

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

13-12-2017

| Document brevet cité au rapport de recherche | | Date de publication | Membre(s) de la famille de brevet(s) | | Date de publication |
|---|---|---|---|---|---|
| EP 2671756 | A2 | 11-12-2013 | CN | 103486511 A | 01-01-2014 |
| | | | EP | 2671756 A2 | 11-12-2013 |
| | | | JP | 6166104 B2 | 19-07-2017 |
| | | | JP | 2013258145 A | 26-12-2013 |
| | | | US | 2013329445 A1 | 12-12-2013 |
| EP 0531185 | A1 | 10-03-1993 | DE | 69202028 D1 | 18-05-1995 |
| | | | DE | 69202028 T2 | 24-08-1995 |
| | | | EP | 0531185 A1 | 10-03-1993 |
| | | | FR | 2680860 A1 | 05-03-1993 |
| | | | JP | H06171396 A | 21-06-1994 |
| | | | US | 5673995 A | 07-10-1997 |
| US 2003193815 | A1 | 16-10-2003 | AUCUN | | |
| EP 1914116 | A2 | 23-04-2008 | CN | 101165392 A | 23-04-2008 |
| | | | EP | 1914116 A2 | 23-04-2008 |
| | | | JP | 4631838 B2 | 23-02-2011 |
| | | | JP | 2008100653 A | 01-05-2008 |
| | | | KR | 20080035958 A | 24-04-2008 |
| | | | US | 2009073709 A1 | 19-03-2009 |
| JP 2011187331 | A | 22-09-2011 | JP | 5444046 B2 | 19-03-2014 |
| | | | JP | 2011187331 A | 22-09-2011 |
| DE 102006031345 | A1 | 10-01-2008 | CN | 101535710 A | 16-09-2009 |
| | | | DE | 102006031345 A1 | 10-01-2008 |
| | | | EP | 2041483 A2 | 01-04-2009 |
| | | | TW | 200811398 A | 01-03-2008 |
| | | | US | 2012182755 A1 | 19-07-2012 |
| | | | US | 2013135855 A1 | 30-05-2013 |
| | | | WO | 2008003289 A2 | 10-01-2008 |

EPO FORM P0460